# EUROPEAN PATENT APPLICATION

(11) **EP 4 835 503 A1**
(43) Date of publication of application: **04.11.2026**
(21) Application number: 24910057.9
(22) Date of filing: 23.09.2024
(51) Int. Cl.: G01R 31/387, G01R 31/392

(54) **BATTERY CAPACITY CONFIDENCE, CAPACITY AND SOH DETERMINATION METHOD, APPARATUS, MEDIUM AND DEVICE**

(30) Priority: 25.12.2023 CN 202311817788
(71) Applicant: BYD Company Limited, Shenzhen, Guangdong 518118 (CN)
(72) Inventor: DENG, Linwang, Shenzhen, Guangdong 518118 (CN); CAO, Huili, Shenzhen, Guangdong 518118 (CN); LI, Xiaoqian, Shenzhen, Guangdong 518118 (CN); FENG, Tianyu, Shenzhen, Guangdong 518118 (CN)
(74) Representative: Mathys & Squire
(86) International application number: PCT/CN2024/120487
(87) International publication number: WO 2025/139113

(57) **Abstract**

Battery capacity confidence level, capacity, and SOH determining methods, an apparatus, a medium, and a device are provided, and relate to the field of vehicle battery technologies. The method includes: determining a corresponding target operating parameter based on a triggered target algorithm; further determining a candidate confidence level set according to the target algorithm and the corresponding target operating parameter, where the candidate confidence level set includes a candidate capacity confidence level corresponding to a candidate battery capacity obtained through calculation according to each preset algorithm in the target algorithm; and then determining a target capacity confidence level of a target battery based on an original capacity confidence level corresponding to an original battery capacity and a candidate capacity confidence level corresponding to each candidate battery capacity.

## Description

### CROSS-REFERENCE TO RELATED APPLICATIONS

The present disclosure claims priority to Chinese Patent Application No. 202311817788.0, filed with the China National Intellectual Property Administration on December 25, 2023 and entitled "BATTERY CAPACITY CONFIDENCE LEVEL, CAPACITY, AND SOH DETERMINING METHODS, APPARATUS, MEDIUM, AND DEVICE", which is incorporated herein by reference in its entirety.

### TECHNICAL FIELD

The present disclosure relates to the field of vehicle battery technologies, and specifically, to battery capacity confidence level, capacity, and SOH determining methods, an apparatus, a storage medium, and a vehicle device.

### BACKGROUND

Battery capacity is an important parameter for evaluating battery state of health. In related technologies, determining battery capacity by using a single method causes the determined battery capacity to be inaccurate, and consequently, a battery state of health obtained through calculation is inaccurate.

### SUMMARY

An objective of the present disclosure is to provide battery capacity confidence level, capacity, SOH (battery state of health) determining methods, an apparatus, a storage medium, and a vehicle device. A corresponding target operating parameter is determined based on a triggered target algorithm; a candidate confidence level set is further determined according to the target algorithm and the corresponding target operating parameter, wherein the candidate confidence level set includes a candidate capacity confidence level corresponding to a candidate battery capacity obtained through calculation according to each preset algorithm in the target algorithm; and then a target capacity confidence level of a target battery is determined based on an original capacity confidence level corresponding to an original battery capacity and a candidate capacity confidence level corresponding to each candidate battery capacity. In this way, a target battery capacity can be determined based on the target capacity confidence level, so that a target battery capacity that better matches a current situation can be determined based on different conditions of the battery, and therefore the original battery capacity is accurately updated based on the target battery capacity, thereby obtaining a more accurate battery capacity state of health.

To achieve the foregoing objective, according to a first aspect of embodiments of the present disclosure, a battery capacity confidence level determining method is provided, including:
determining a target algorithm based on a trigger parameter of a target battery, and the target algorithm being at least one of a plurality of preset algorithms;
obtaining a candidate confidence level set according to the target algorithm and a target operating parameter of the target battery that corresponds to the target algorithm, and the candidate confidence level set including a candidate capacity confidence level corresponding to a candidate battery capacity obtained through calculation according to each preset algorithm in the target algorithm; and
determining a target capacity confidence level of the target battery based on an original capacity confidence level corresponding to an original battery capacity and a candidate capacity confidence level corresponding to each candidate battery capacity.

Optionally, the plurality of preset algorithms include at least two of an ampere-hour integral method, an inflection point positioning method, and a calendar-life method.

The trigger parameter includes at least one of a first state of charge, a second state of charge, and a charging rate that are of the target battery during charging, and the first state of charge is less than the second state of charge.

Optionally, determining the target algorithm based on the trigger parameter of the target battery includes:
when the first state of charge is less than a first preset threshold and the second state of charge is a full charging state, determining that the target algorithm includes the ampere-hour integral method and the calendar-life method.

Optionally, determining the target algorithm based on the trigger parameter of the target battery includes:
when the first state of charge is less than a second preset threshold, the second state of charge is a full charging state, and the charging rate is less than a preset rate, determining that the target algorithm includes the inflection point positioning method and the calendar-life method.

Optionally, the target operating parameter includes a confidence level parameter.

Obtaining the candidate confidence level set according to the target algorithm and the target operating parameter of the target battery that corresponds to the target algorithm includes:
for any preset algorithm in the target algorithm, determining, based on a confidence level parameter corresponding to the preset algorithm, a candidate capacity confidence level of a candidate battery capacity corresponding to the preset algorithm.

Optionally, when any preset algorithm is the ampere-hour integral method, the confidence level parameter includes a static voltage corresponding to the first state of charge and stabilization duration corresponding to the static voltage; and
determining, based on the confidence level parameter corresponding to the preset algorithm, the candidate capacity confidence level of the candidate battery capacity corresponding to the preset algorithm includes:
determining, based on the stabilization duration of the static voltage and a target interval in which the static voltage is located, a first candidate capacity confidence level of a candidate battery capacity corresponding to the ampere-hour integral method, the target interval being one of a platform region and a ramp region of a low charge interval in a voltage characteristic curve of the target battery, and the first candidate capacity confidence level being positively correlated with the stabilization duration.

Optionally, when any preset algorithm is the inflection point positioning method, the confidence level parameter includes a candidate state of health of the target battery; and
determining, based on the confidence level parameter corresponding to the preset algorithm, the candidate capacity confidence level of the candidate battery capacity corresponding to the preset algorithm includes:
determining, based on the candidate state of health of the target battery, a second candidate capacity confidence level of a candidate battery capacity corresponding to the inflection point positioning method, and the second candidate capacity confidence level being positively correlated with the candidate state of health.

Optionally, when any preset algorithm is the calendar-life method, the confidence level parameter includes a drive mileage and a drive time of the target battery; and
determining, based on the confidence level parameter corresponding to the preset algorithm, the candidate capacity confidence level of the candidate battery capacity corresponding to the preset algorithm includes:
determining, based on the drive mileage and the drive time, a third candidate capacity confidence level of a candidate battery capacity corresponding to the calendar-life method, and the third candidate capacity confidence level being negatively related to the drive mileage and the drive time.

Optionally, before determining the target capacity confidence level of the target battery based on the original capacity confidence level corresponding to the original battery capacity and the candidate capacity confidence level corresponding to each candidate battery capacity, the method further includes:
obtaining a fourth candidate capacity confidence level corresponding to the original battery capacity and original update duration, and the original update duration being a duration from a moment at which a battery capacity of the target battery is updated to the original battery capacity to a current moment; and
determining, based on the fourth candidate capacity confidence level and the original update duration, the original capacity confidence level corresponding to the original battery capacity, and the original capacity confidence level being negatively correlated with the original update duration.

Optionally, before determining the target capacity confidence level of the target battery based on the original capacity confidence level corresponding to the original battery capacity and the candidate capacity confidence level corresponding to each candidate battery capacity, the method further includes:
obtaining a fourth candidate capacity confidence level corresponding to the original battery capacity and an original throughput, and the original throughput being a total charging/discharging amount of the target battery in a time period corresponding to original update duration; and
determining, based on the fourth candidate capacity confidence level and the original throughput, the original capacity confidence level corresponding to the original battery capacity, and the original capacity confidence level being negatively correlated with the original throughput.

According to a second aspect of embodiments of the present disclosure, a battery capacity determining method is provided, including:
determining a target algorithm based on a trigger parameter of a target battery, and the target algorithm being at least one of a plurality of preset algorithms;
obtaining at least one group of candidate battery capacity parameters according to the target algorithm and a target operating parameter of the target battery that corresponds to the target algorithm, a preset algorithm in the target algorithm being in a one-to-one correspondence with the candidate battery capacity parameter, and each group of candidate battery capacity parameters including a candidate battery capacity and a candidate capacity confidence level corresponding to the candidate battery capacity; and
determining, based on an original capacity confidence level corresponding to an original battery capacity and a candidate capacity confidence level corresponding to each candidate battery capacity, a target battery capacity from the original battery capacity and the candidate battery capacity, and the target battery capacity being used to update the current original battery capacity.

Optionally, the plurality of preset algorithms include at least two of an ampere-hour integral method, an inflection point positioning method, and a calendar-life method.

The trigger parameter includes at least one of a first state of charge, a second state of charge, and a charging rate that are of the target battery during charging, and the first state of charge is less than the second state of charge.

Optionally, determining the target algorithm based on the trigger parameter of the target battery includes:
when the first state of charge is less than a first preset threshold and the second state of charge is a full charging state, determining that the target algorithm includes the ampere-hour integral method and the calendar-life method.

Optionally, determining the target algorithm based on the trigger parameter of the target battery includes:
when the first state of charge is less than a second preset threshold, the second state of charge is a full charging state, and the charging rate is less than a preset rate, determining that the target algorithm includes the inflection point positioning method and the calendar-life method.

Optionally, the target operating parameter includes a capacity parameter and a confidence level parameter.

Obtaining the at least one group of candidate battery capacity parameters according to the target algorithm and the target operating parameter of the target battery that corresponds to the target algorithm includes:
for any preset algorithm in the target algorithm, determining, based on a capacity parameter corresponding to the preset algorithm, a candidate battery capacity corresponding to the preset algorithm; and
determining, based on a confidence level parameter corresponding to the preset algorithm, a candidate capacity confidence level of the candidate battery capacity corresponding to the preset algorithm.

Optionally, when any preset algorithm is the ampere-hour integral method, the confidence level parameter includes a static voltage corresponding to the first state of charge and stabilization duration corresponding to the static voltage; and
determining, based on the confidence level parameter corresponding to the preset algorithm, the candidate capacity confidence level of the candidate battery capacity corresponding to the preset algorithm includes:
determining, based on the stabilization duration of the static voltage and a target interval in which the static voltage is located, a first candidate capacity confidence level of a candidate battery capacity corresponding to the ampere-hour integral method, the target interval being one of a platform region and a ramp region of a low charge interval in a voltage characteristic curve of the target battery, and the first candidate capacity confidence level being positively correlated with the stabilization duration.

Optionally, when any preset algorithm is the inflection point positioning method, the confidence level parameter includes a state of health of the target battery; and
determining, based on the confidence level parameter corresponding to the preset algorithm, the candidate capacity confidence level of the candidate battery capacity corresponding to the preset algorithm includes:
determining, based on the state of health of the target battery, a second candidate capacity confidence level of a candidate battery capacity corresponding to the inflection point positioning method, and the second candidate capacity confidence level being positively correlated with the state of health.

Optionally, when any preset algorithm is the calendar-life method, the confidence level parameter includes a drive mileage and a drive time of the target battery; and
determining, based on the confidence level parameter corresponding to the preset algorithm, the candidate capacity confidence level of the candidate battery capacity corresponding to the preset algorithm includes:
determining, based on the drive mileage and the drive time, a third candidate capacity confidence level of a candidate battery capacity corresponding to the calendar-life method, and the third candidate capacity confidence level being negatively related to the drive mileage and the drive time.

Optionally, determining, based on the original capacity confidence level corresponding to the original battery capacity and the candidate capacity confidence level corresponding to each candidate battery capacity, the target battery capacity from the original battery capacity and the candidate battery capacity includes:
determining a battery capacity corresponding to a maximum value in the original capacity confidence level and the candidate capacity confidence level corresponding to each candidate battery capacity as the target battery capacity.

Optionally, before determining, based on the original capacity confidence level corresponding to the original battery capacity and the candidate capacity confidence level corresponding to each candidate battery capacity, the target battery capacity from the original battery capacity and the candidate battery capacity, the method further includes:
obtaining a fourth candidate capacity confidence level corresponding to the original battery capacity, original update duration, and an original throughput, the original update duration being duration from a moment at which a battery capacity of the target battery is updated to the original battery capacity to a current moment, and the original throughput being a total charge/discharge amount of the target battery in a time period corresponding to the original update duration; and
determining, based on the fourth candidate capacity confidence level, the original update duration, and the original throughput, the original capacity confidence level corresponding to the original battery capacity, and the original capacity confidence level being negatively correlated with the original update duration and the original throughput.

According to a third aspect of embodiments of the present disclosure, a battery capacity state of health determining method is provided, including:
determining a battery capacity state of health of a target battery based on a target battery capacity and a factory capacity of the target battery, and the target battery capacity being obtained according to the battery capacity confidence level determining method provided in the first aspect of the present disclosure.

According to a fourth aspect of embodiments of the present disclosure, an apparatus is provided, including:
a memory, storing a computer program; and
a processor, configured to execute the computer program in the memory, to enable the apparatus to perform steps of the battery capacity confidence level determining method provided in the first aspect of the present disclosure; or to enable the apparatus to perform steps of the battery capacity determining method provided in the second aspect of the present disclosure; or to enable the apparatus to perform steps of the battery capacity state of health determining method provided in the third aspect of the present disclosure.

According to a fifth aspect of embodiments of the present disclosure, a non-volatile storage medium is provided. The non-volatile storage medium stores a computer program. When the program is executed by a processor, steps of the battery capacity confidence level determining method provided in the first aspect of the present disclosure are implemented; or when the program is executed by a processor, steps of the battery capacity determining method provided in the second aspect of the present disclosure are implemented; or when the program is executed by a processor, steps of the battery capacity state of health determining method provided in the third aspect of the present disclosure are implemented.

According to a sixth aspect of embodiments of the present disclosure, an electric energy device is provided, including the apparatus provided in the fifth aspect of the present disclosure.

According to the foregoing technical solutions, a corresponding target operating parameter is determined based on a triggered target algorithm; a candidate confidence level set is further determined according to the target algorithm and the corresponding target operating parameter, where the candidate confidence level set includes a candidate capacity confidence level corresponding to a candidate battery capacity obtained through calculation according to each preset algorithm in the target algorithm; and then a target capacity confidence level of a target battery is determined based on an original capacity confidence level corresponding to an original battery capacity and a candidate capacity confidence level corresponding to each candidate battery capacity. In this way, a target battery capacity can be determined based on the target capacity confidence level, so that a target battery capacity that better matches a current situation can be determined based on different conditions of the battery, and therefore the original battery capacity is accurately updated based on the target battery capacity, thereby obtaining a more accurate battery capacity state of health.

Additional features and benefits of the present disclosure are described in detail in the following specific implementation part.

### BRIEF DESCRIPTION OF DRAWINGS

The accompanying drawings are intended to provide a further understanding of the present disclosure, form a part of this specification, and together with the following specific implementations, are used to explain the present disclosure, but do not constitute a limitation on the present disclosure. In the accompanying drawings:
FIG. 1 is a flowchart of a battery capacity determining method according to an example embodiment;
FIG. 2 is a flowchart of a battery capacity update method according to an example embodiment;
FIG. 3 is a diagram of a voltage characteristic curve of a battery according to an example embodiment; and
FIG. 4 is a block diagram of a battery capacity determining apparatus according to an example embodiment.

### DESCRIPTION OF EMBODIMENTS

The following describes in detail specific implementations of the present disclosure with reference to the accompanying drawings. It will be understood that the specific implementations described herein are only used to illustrate and explain the present disclosure and are not intended to limit the present disclosure.

Battery capacity is an important parameter for evaluating battery state of health. A method for obtaining battery capacity through calculation may include an ampere-hour integral method, a calendar-life method, and an inflection point positioning method. The ampere-hour integral method requires larger discharge depth, and actual available capacity of the battery is obtained through calculation based on changes of surge capacity and state of charge. In the calendar-life method, a battery capacity trend with aging may be obtained based on parameters such as time, battery throughput and self-discharging rate by using a calendar-life model. The inflection point positioning method requires that a voltage characteristic curve be displayed in a case of a low current, and an actual available capacity is obtained by positioning an inflection point.

In related technologies, determining battery capacity by using a single method causes the determined battery capacity to be inaccurate, and consequently, a battery state of health obtained through calculation is inaccurate.

In view of the foregoing technical problem, the present disclosure provides battery capacity confidence level, capacity, and SOH determining methods, an apparatus, a storage medium, and a vehicle device. A corresponding target operating parameter is determined based on a triggered target algorithm; a candidate confidence level set is further determined according to the target algorithm and the corresponding target operating parameter, where the candidate confidence level set includes a candidate capacity confidence level corresponding to a candidate battery capacity obtained through calculation according to each preset algorithm in the target algorithm; and then a target capacity confidence level of a target battery is determined based on an original capacity confidence level corresponding to an original battery capacity and a candidate capacity confidence level corresponding to each candidate battery capacity. In this way, a target battery capacity can be determined based on the target capacity confidence level, so that a target battery capacity that better matches a current situation can be determined based on different conditions of the battery, and therefore the original battery capacity is accurately updated based on the target battery capacity, thereby obtaining a more accurate battery capacity state of health.

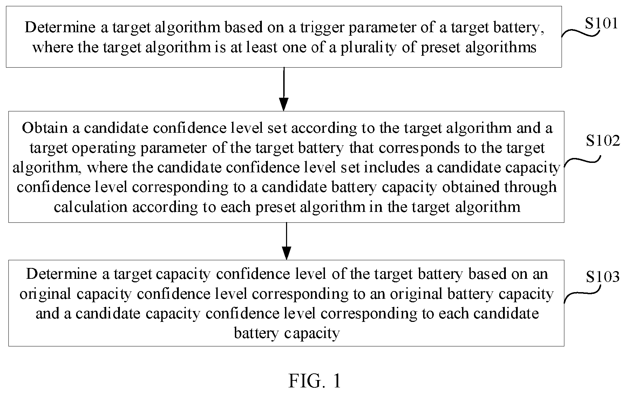

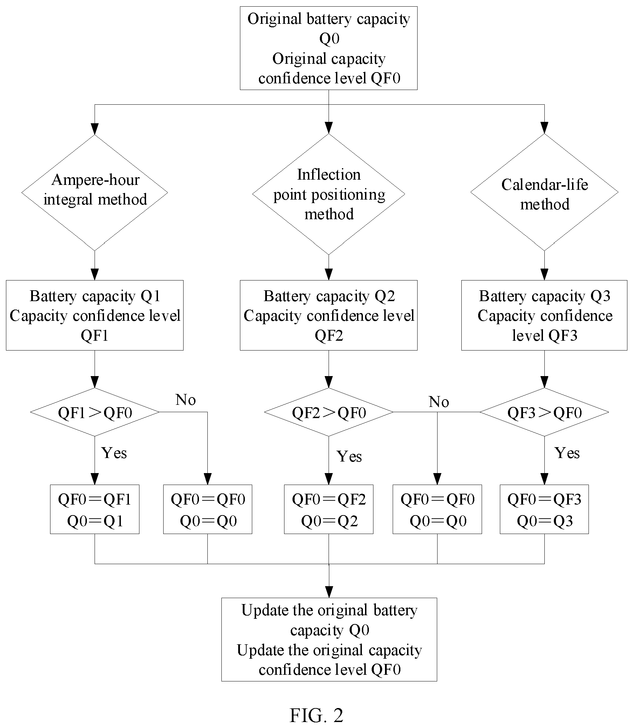

FIG. 1 is a flowchart of a battery capacity confidence level determining method according to an example embodiment, and FIG. 2 is a flowchart of a battery capacity update method according to an example embodiment. As shown in FIG. 1 and FIG. 2, the method may include the following steps.

Step S101: determine a target algorithm based on a trigger parameter of a target battery, where the target algorithm is at least one of a plurality of preset algorithms.

In this implementation, the target battery is a battery whose battery capacity is to be determined, and the plurality of preset algorithms could be preset. For example, the plurality of preset algorithms may include at least two of an ampere-hour integral method, a calendar-life method, and an inflection point positioning method. A corresponding trigger condition is set for each preset algorithm. Which preset algorithm whose trigger condition is met by the trigger parameter of the target battery may be determined based on the trigger parameter, and then at least one preset algorithm is determined from the plurality of preset algorithms, to obtain the target algorithm. For a trigger condition of any preset algorithm, if the trigger parameter meets the trigger condition of any preset algorithm, the preset algorithm may be triggered, and the preset algorithm is determined as one algorithm in the target algorithm. The trigger parameter may include at least one of a first state of charge, a second state of charge, and a charging rate that are of the target battery during charging, and the first state of charge is less than the second state of charge. The first state of charge may be an initial state of charge of the target battery during current charging, and the second state of charge may be an end state of charge of the target battery during current charging.

Step S102: obtain a candidate confidence level set according to the target algorithm and a target operating parameter of the target battery that corresponds to the target algorithm, wherein the candidate confidence level set includes a candidate capacity confidence level corresponding to a candidate battery capacity obtained through calculation according to each preset algorithm in the target algorithm.

In this implementation, the target operating parameter corresponding to each preset algorithm may be first obtained based on each preset algorithm in the target algorithm, and the target operating parameter may be determined from an operating parameter of the target battery. The candidate confidence level set is obtained through calculation based on the target operating parameter corresponding to each preset algorithm and based on the corresponding preset algorithm, and the candidate confidence level set includes the candidate capacity confidence level corresponding to the candidate battery capacity obtained through calculation according to each preset algorithm in the target algorithm. That is, one corresponding candidate battery capacity and a candidate capacity confidence level corresponding to the candidate battery capacity can be obtained through calculation according to each preset algorithm in the target algorithm, and the candidate capacity confidence level represents an accuracy degree of the corresponding candidate battery capacity.

Step S103: determine a target capacity confidence level of the target battery based on an original capacity confidence level corresponding to an original battery capacity and a candidate capacity confidence level corresponding to each candidate battery capacity.

In this implementation, a target battery capacity may be selected based on values of confidence levels corresponding to a plurality of battery capacities. Specifically, the candidate capacity confidence level corresponding to each candidate battery capacity and the original capacity confidence level corresponding to the original battery capacity may be obtained. The values of the plurality of confidence levels are compared, and a maximum value of the confidence levels may be determined as the target capacity confidence level of the target battery. The original battery capacity is a current battery capacity, and is a battery capacity after a last update. If this is the first time to trigger determining the target battery capacity of the target battery, a value of the original battery capacity may be 0, and the original capacity confidence level may also be 0.

After the target capacity confidence level is obtained, a candidate battery capacity corresponding to the target capacity confidence level may be determined as the target battery capacity, so as to update the current original battery capacity, to obtain the latest and more accurate battery capacity of the target battery.

In a possible implementation, for trigger conditions of various preset algorithms, the calendar-life method may be triggered in real time, that is, a corresponding candidate battery capacity and a candidate capacity confidence level corresponding to the candidate battery capacity may be obtained in real time based on the calendar-life method.

In a possible implementation, determining the target algorithm based on the trigger parameter of the target battery may include the following steps:
when the first state of charge is less than a first preset threshold and the second state of charge is a full charging state, determining that the target algorithm includes the ampere-hour integral method and the calendar-life method.

In this implementation, the calendar-life method is triggered in real time, that is, the target algorithm includes the calendar-life method. When the first state of charge is less than the first preset threshold, and the second state of charge is the full charging state, determining that the trigger parameter meets a trigger condition corresponding to the ampere-hour integral method may determine that the target algorithm further includes the ampere-hour integral method. The first preset threshold may be set based on an actual situation, and may be adjusted based on different battery types. For example, a value range of the first preset threshold may be 1% to 35%. The full charging state means that a state of charge of the battery is at least greater than 97%.

In a possible implementation, determining the target algorithm based on the trigger parameter of the target battery may include the following steps:
when the first state of charge is less than a second preset threshold, the second state of charge is a full charging state, and the charging rate is less than a preset rate, determining that the target algorithm includes the inflection point positioning method and the calendar-life method.

In this implementation, the calendar-life method is triggered in real time, that is, the target algorithm includes the calendar-life method. When the first state of charge is less than the second preset threshold, and the second state of charge is the full charging state, determining that the trigger parameter meets a trigger condition corresponding to the inflection point positioning method may determine that the target algorithm further includes the inflection point positioning method. The second preset threshold is greater than the first preset threshold, and the second preset threshold may be set based on an actual situation, or may be adjusted based on different battery types. For example, a value range of the second preset threshold may be 55% to 65%. The full charging state means that a state of charge of the battery is at least greater than 97%.

In a possible implementation, the target operating parameter includes a confidence level parameter.

Obtaining the candidate confidence level set according to the target algorithm and the target operating parameter of the target battery that corresponds to the target algorithm may include the following steps:
for any preset algorithm in the target algorithm, determining, based on a confidence level parameter corresponding to the preset algorithm, a candidate capacity confidence level of a candidate battery capacity corresponding to the preset algorithm.

In this implementation, the target operating parameter includes the confidence level parameter, and the confidence level parameter is used to determine a confidence level corresponding to a battery capacity. Further, the candidate capacity confidence level of the candidate battery capacity corresponding to the preset algorithm may be determined based on the confidence level parameter corresponding to the preset algorithm.

In a possible implementation, the target operating parameter may further include a capacity parameter, and battery capacity calculation is performed for each preset algorithm in the target algorithm, to obtain a candidate battery capacity parameter corresponding to each preset algorithm. Specifically, for any preset algorithm in the target algorithm, one candidate battery capacity corresponding to the preset algorithm may be obtained through calculation based on a capacity parameter corresponding to the preset algorithm and based on the preset algorithm.

In the ampere-hour integral method, a battery capacity of the target battery may be obtained by using a capacity ΔQ/ΔSOC accumulated in a process that begins at a known SOC (battery state of charge) and proceeds to a full charging state, where ΔQ is a surge capacity, and ΔSOC is a change value of the SOC after charging is completed. Accuracy of the method is based on a value of ΔSOC and accuracy of the SOC. That is, a capacity parameter corresponding to the ampere-hour integral method is the surge capacity and the change value of the SOC after charging is completed. In the inflection point positioning method, a position of a high inflection point is determined by using a voltage characteristic curve that appears when a low current is used for charging, and according to a principle that a capacity Q1 at the position of the high inflection point remains unchanged after aging, a final capacity is obtained through calculation by using a method of charging a capacity Q2+Q1 after the high inflection point, where Q1 is the capacity at the inflection point, and Q2 is a surge capacity after the inflection point. That is, a capacity parameter corresponding to the inflection point positioning method is the capacity at the inflection point and the surge capacity after the inflection point. Computational accuracy of the method depends on accuracy of the capacity at the high inflection point. In the calendar-life method, a state of health of the battery is obtained through calculation in real time by using an input mileage and a time of the model, to output a corresponding capacity value. When the ampere-hour integral method and the inflection point positioning method are not triggered for a long time, the capacity value obtained by the method can be updated in a specific step. That is, a capacity parameter corresponding to the calendar-life method is a drive mileage and a drive time of the target battery, and the drive time is a factory use time of the target battery.

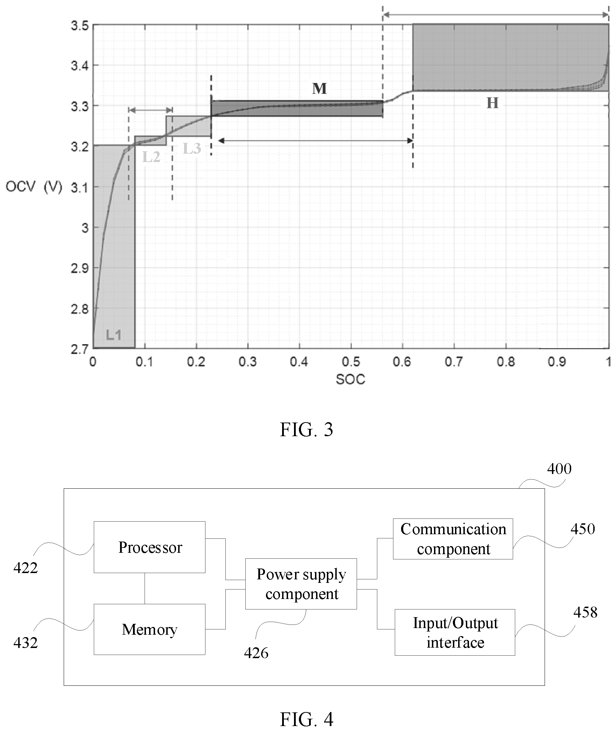

FIG. 3 is a diagram of a voltage characteristic curve of the battery according to an example embodiment. As shown in FIG. 3, in a possible implementation, when any preset algorithm is the ampere-hour integral method, the confidence level parameter corresponding to any preset algorithm includes a static voltage corresponding to the first state of charge and stabilization duration corresponding to the static voltage. Determining, based on the confidence level parameter corresponding to the preset algorithm, the candidate capacity confidence level of the candidate battery capacity corresponding to the preset algorithm may include the following steps:
determining, based on the stabilization duration of the static voltage and a target interval in which the static voltage is located, a first candidate capacity confidence level of a candidate battery capacity corresponding to the ampere-hour integral method, the target interval being one of a platform region and a ramp region of a low charge interval in a voltage characteristic curve of the target battery, and the first candidate capacity confidence level being positively correlated with the stabilization duration.

In this implementation, the target battery may be a lithium-ion battery, and the voltage characteristic curve of the target battery is a curve in which an OCV (, open-circuit voltage) of the battery changes with the state of charge of the battery. As shown in FIG. 3, the voltage characteristic curve includes a low charge interval L, a medium charge interval M, and a high charge interval H. The low charge interval L sequentially includes three regions: L1, L2, and L3, L1 and L3 are ramp regions, and L2 is a platform region.

The first state of charge may be determined by using the static voltage, and the stabilization duration of the static voltage is a standing time in which the target battery is charged or discharged to reach the static voltage, that is, a standing time of the target battery before the static voltage. This standing time is a duration of neither charging nor discharging. When the preset algorithm is the ampere-hour integral method, a confidence level parameter corresponding to the ampere-hour integral method may be obtained: the static voltage corresponding to the first state of charge and the stabilization duration corresponding to the static voltage, an interval corresponding to the static voltage is first determined, and then the first candidate capacity confidence level of the candidate battery capacity obtained by using the ampere-hour integral method is determined based on the stabilization duration.

For example, a change value of the SOC relates to a start SOC and a full charging SOC, and the full charging SOC is a fixed value of 100%. Therefore, for ampere-hour integration, factors that affect the candidate capacity confidence level of the candidate battery capacity mainly depend on accuracy of an SOC at a low point, that is, accuracy of the first state of charge. The SOC at the low point may be determined by using the static voltage. To be specific, after discharging or charging ends, voltage starts to recover to a stable state. As time goes on, the voltage recovers more stably. In this case, a current SOC value may be obtained by checking a state of charge corresponding to the voltage, so as to obtain the first state of charge. Accuracy of the SOC is affected by voltage position and standing time. When the voltage falls in the ramp region, for example, L1 or L3, the SOC has a degree of recognition. Therefore, accuracy of the SOC is higher under the same standing time. In this case, the SOC can be given a higher quality factor. However, when the voltage falls in the platform region, a degree of distinguishability is lower. Therefore, accuracy of the SOC is low, and the quality factor of the SOC increases with prolongation of the standing time. For example, when the voltage falls in the ramp region and the standing time is greater than or equal to first preset duration, a confidence level of the first state of charge may be a first confidence value, a value range of the first preset duration may be 0.1 hour to 5 hours, and a value range of the first confidence value may be 70% to 100%; or when the standing time is less than first preset duration, a confidence level may be 0 or increases with an increase of the standing time. When the voltage falls in the platform region and the standing time is greater than or equal to first preset duration, a confidence level of the first state of charge may be a second confidence value, a first confidence value is greater than the second confidence value, a value range of the second confidence value may be 65% to 75%, as the standing time increases, the confidence level of the first state of charge increases linearly, and when the standing time reaches second preset duration, the confidence level of the first state of charge increases to the first confidence value, and a value range of the second preset duration may be 5.5 hours to 20 hours; or when the standing time is less than first preset duration, a confidence level may be 0 or increases with an increase of the standing time.

In a possible implementation, when any preset algorithm is the inflection point positioning method, the confidence level parameter corresponding to any preset algorithm includes a candidate state of health of the target battery.

Determining, based on the confidence level parameter corresponding to the preset algorithm, the candidate capacity confidence level of the candidate battery capacity corresponding to the preset algorithm may include the following steps:
determining, based on the candidate state of health of the target battery, a second candidate capacity confidence level of a candidate battery capacity corresponding to the inflection point positioning method, and the second candidate capacity confidence level being positively correlated with the candidate state of health.

In this implementation, the candidate state of health of the target battery, that is, an SOH, may be obtained to determine the second candidate capacity confidence level of the candidate battery capacity corresponding to the inflection point positioning method, and the candidate state of health may be determined based on the candidate battery capacity obtained through calculation based on the inflection point positioning method. The second candidate capacity confidence level is positively correlated with the candidate state of health, that is, a larger value of the candidate state of health indicates a larger second candidate capacity confidence level.

For example, in the inflection point positioning method, a capacity from an inflection point, namely, a ramp region between M and H regions in FIG. 3, to full charging is used to infer a final capacity of the battery, namely, a sum of a capacity Q1 at the inflection point and a surge capacity Q2 after the inflection point. The surge capacity Q2 from the inflection point to full charging is an accurate value and is not affected by other factors. Therefore, a main factor affecting the inflection point positioning method is accuracy of the capacity Q1 at the inflection point, namely, a change of a position of the inflection point. However, the position of the inflection point is affected only by an aging degree of the battery, that is, affected by the state of health of the battery. As the battery pack ages, the position of the inflection point shifts. Therefore, accuracy of the capacity at the inflection point decreases. Therefore, for a new battery pack, SOH=100%, a confidence level of a battery capacity obtained through calculation by using the inflection point positioning method is a third confidence value, and a value range of the third confidence value may be 85% to 95%. As the battery pack ages, the confidence level of the battery capacity obtained through calculation decreases linearly. When the SOH of the battery pack decreases to a first preset health value, the confidence level of the battery capacity decreases to a fourth confidence value. A value range of the first preset health value may be 65% to 75%, and a value range of the fourth confidence value may be 55% to 65%.

In a possible implementation, when any preset algorithm is the calendar-life method, the confidence level parameter includes a drive mileage and a drive time of the target battery.

Determining, based on the confidence level parameter corresponding to the preset algorithm, the candidate capacity confidence level of the candidate battery capacity corresponding to the preset algorithm may include the following steps:
determining, based on the drive mileage and the drive time, a third candidate capacity confidence level of a candidate battery capacity corresponding to the calendar-life method, and the third candidate capacity confidence level being negatively related to the drive mileage and the drive time.

In this implementation, a confidence level parameter corresponding to the calendar-life method may be obtained: the drive mileage and the drive time of the target battery, where the drive mileage is a mileage driven by using the target battery, and the drive time is a factory use time of the target battery. Further, the third candidate capacity confidence level of the candidate battery capacity corresponding to the calendar-life method is determined based on the drive mileage and the drive time. The third candidate capacity confidence level is negatively related to the drive mileage and the drive time, that is, a larger drive mileage indicates a smaller third candidate capacity confidence level, and a longer drive time indicates a smaller third candidate capacity confidence level.

In a possible implementation, before the target battery capacity is determined from the original battery capacity and the candidate battery capacity based on the original capacity confidence level corresponding to the original battery capacity and the candidate capacity confidence level corresponding to each candidate battery capacity, the original capacity confidence level corresponding to the original battery capacity may further be first determined, and the determining method of the original capacity confidence level corresponding to the original battery capacity may include the following steps:
obtaining a fourth candidate capacity confidence level corresponding to the original battery capacity and original update duration, and the original update duration being duration from a moment at which a battery capacity of the target battery is updated to the original battery capacity to a current moment; and determining, based on the fourth candidate capacity confidence level and the original update duration, the original capacity confidence level corresponding to the original battery capacity, and the original capacity confidence level being negatively correlated with the original update duration.

In a possible implementation, before the target battery capacity is determined from the original battery capacity and the candidate battery capacity based on the original capacity confidence level corresponding to the original battery capacity and the candidate capacity confidence level corresponding to each candidate battery capacity, the original capacity confidence level corresponding to the original battery capacity may further be first determined, and the determining method of the original capacity confidence level corresponding to the original battery capacity may include the following steps:
obtaining a fourth candidate capacity confidence level corresponding to the original battery capacity and an original throughput, and the original throughput being a total charging/discharging amount of the target battery in a time period corresponding to original update duration; and determining, based on the fourth candidate capacity confidence level and the original throughput, the original capacity confidence level corresponding to the original battery capacity, and the original capacity confidence level being negatively correlated with the original throughput.

In this implementation, the fourth candidate capacity confidence level corresponding to the original battery capacity may be updated based on at least one of the original update duration and the original throughput, to obtain the original capacity confidence level. The fourth candidate capacity confidence level corresponding to the original battery capacity is a confidence level corresponding to the original battery capacity determined based on a corresponding confidence level parameter when the original battery capacity is obtained through calculation. After any algorithm is triggered, based on the confidence level of the battery capacity, a larger confidence level is selected to update the current original battery capacity and the original capacity confidence level. As a use time and a throughput of the battery increase, that is, the original update duration and the original throughput increase, the confidence level corresponding to the original battery capacity gradually decreases based on the fourth candidate capacity confidence level, and until a confidence level after any algorithm is triggered is greater than the confidence level corresponding to the original battery capacity, the confidence level corresponding to the original battery capacity can be updated again. For example, after the confidence level is updated to the fourth candidate capacity confidence level corresponding to the original battery capacity, when an accumulated capacity exceeds one nominal capacity per cycle, the confidence level corresponding to the original battery capacity decreases by a first preset value. A value range of the first preset value may be 1% to 2%. For every additional five days of time, the confidence level corresponding to the original battery capacity decreases by a second preset value. A value range of the second preset value may be 1% to 2%.

In another example embodiment, a battery capacity determining method is further provided, including:
determining a target algorithm based on a trigger parameter of a target battery, and the target algorithm being at least one of a plurality of preset algorithms;
obtaining a candidate battery capacity set according to the target algorithm and a target operating parameter of the target battery that corresponds to the target algorithm, and the candidate battery capacity set including a candidate battery capacity obtained through calculation according to each preset algorithm in the target algorithm; and
determining a candidate battery capacity obtained through calculation according to a preset algorithm corresponding to a target capacity confidence level as a target battery capacity of the target battery, the target battery capacity being used to update a current original battery capacity, and the target capacity confidence level being obtained according to the battery capacity confidence level determining method in the foregoing embodiments.

In this implementation, the candidate battery capacity set may be further obtained based on the target algorithm and the target operating parameter of the target battery that corresponds to the target algorithm. The candidate battery capacity set includes the candidate battery capacity obtained through calculation according to each preset algorithm in the target algorithm, that is, one corresponding candidate battery capacity may be obtained through calculation according to each preset algorithm in the target algorithm. Then, the target capacity confidence level may be obtained according to the battery capacity confidence level determining method in the foregoing embodiments, and the target battery capacity may be determined from a plurality of candidate battery capacities and the original battery capacity based on the target capacity confidence level. After the target battery capacity is obtained, the current original battery capacity may be updated, to obtain the latest and more accurate battery capacity of the target battery. For a method for obtaining the candidate battery capacity set according to the target algorithm and the target operating parameter of the target battery that corresponds to the target algorithm, refer to related explanations in the foregoing battery capacity confidence level determining method. Details are not described herein again.

In a possible implementation, the battery capacity determining method may include the following steps:
determining a target algorithm based on a trigger parameter of a target battery, and the target algorithm being at least one of a plurality of preset algorithms; obtaining at least one group of candidate battery capacity parameters according to the target algorithm and a target operating parameter of the target battery that corresponds to the target algorithm, a preset algorithm in the target algorithm being in a one-to-one correspondence with the candidate battery capacity parameter, and each group of candidate battery capacity parameters including a candidate battery capacity and a candidate capacity confidence level corresponding to the candidate battery capacity; and determining, based on an original capacity confidence level corresponding to an original battery capacity and a candidate capacity confidence level corresponding to each candidate battery capacity, a target battery capacity from the original battery capacity and the candidate battery capacity, and the target battery capacity being used to update the current original battery capacity.

In this implementation, the target battery is a battery whose battery capacity is to be determined, and the plurality of preset algorithms may be preset. For example, the plurality of preset algorithms may include an ampere-hour integral method, a calendar-life method, an inflection point positioning method, and the like. A corresponding trigger condition is set for each preset algorithm. Which preset algorithm whose trigger condition is met by the trigger parameter of the target battery may be determined based on the trigger parameter, and then at least one preset algorithm is determined from the plurality of preset algorithms, to obtain the target algorithm. For a trigger condition of any preset algorithm, if the trigger parameter meets the trigger condition of any preset algorithm, the preset algorithm may be triggered, and the preset algorithm is determined as one algorithm in the target algorithm. The trigger parameter may include at least one of a first state of charge, a second state of charge, and a charging rate that are of the target battery during charging, and the first state of charge is less than the second state of charge. The first state of charge may be an initial state of charge of the target battery during current charging, and the second state of charge may be an end state of charge of the target battery during current charging.

The target operating parameter corresponding to each preset algorithm may be first obtained based on each preset algorithm in the target algorithm, and the target operating parameter may be determined from an operating parameter of the target battery. The at least one group of candidate battery capacity parameters is obtained through calculation based on the target operating parameter corresponding to each preset algorithm and based on the corresponding preset algorithm, and the preset algorithm in the target algorithm is in a one-to-one correspondence with the candidate battery capacity parameter, that is, a group of corresponding candidate battery capacity parameters can be obtained through calculation according to each preset algorithm in the target algorithm. Each group of candidate battery capacity parameters includes a candidate battery capacity and a candidate capacity confidence level corresponding to the candidate battery capacity, that is, one corresponding candidate battery capacity and a candidate capacity confidence level corresponding to the candidate battery capacity can be obtained through calculation according to each preset algorithm in the target algorithm, and the candidate capacity confidence level represents an accuracy degree of the corresponding candidate battery capacity.

The target battery capacity may be selected based on values of confidence levels corresponding to a plurality of battery capacities. Specifically, the candidate capacity confidence level corresponding to each candidate battery capacity and the original capacity confidence level corresponding to the original battery capacity may be obtained. The values of the plurality of confidence levels are compared, and a battery capacity corresponding to a maximum confidence level is determined as the target battery capacity. The original battery capacity is a current battery capacity, and is a battery capacity after a last update. If this is the first time to trigger determining the target battery capacity of the target battery, a value of the original battery capacity may be 0, and the original capacity confidence level may also be 0. After the target battery capacity is obtained, the current original battery capacity may be updated, to obtain the latest and more accurate battery capacity of the target battery. In another example embodiment, a battery capacity state of health determining method is further provided, including:
determining a battery capacity state of health of a target battery based on a target battery capacity and a factory capacity of the target battery, and the target battery capacity being obtained according to the battery capacity determining method in the foregoing embodiments.

In this implementation, the battery capacity state of health of the target battery may be obtained by directly dividing the target battery capacity by the factory capacity.

FIG. 4 is a block diagram of an apparatus according to an example embodiment. Referring to FIG. 4, the apparatus 400 includes: a processor, wherein there may be one or more processors 422; and a memory 432, configured to store a computer program that can be executed by the processor 422. The computer program stored in the memory 432 may include one or more modules each corresponding to a group of instructions. In addition, the processor 422 may be configured to execute the computer program, so that a battery capacity determining apparatus performs the foregoing battery capacity determining method.

In addition, the apparatus 400 may further include a power supply component 426 and a communication component 490. The power supply component 426 may be configured to perform power management of the apparatus 400, and the communication component 490 may be configured to implement communication of the apparatus 400, for example, wired or wireless communication. In addition, the apparatus 400 may further include an input/output interface 498. The apparatus 400 may perform an operation based on an operating system stored in the memory 432.

In another example embodiment, a vehicle is further provided, including the battery capacity determining apparatus provided in the foregoing embodiments.

In another example embodiment, a non-volatile storage medium including program instructions is further provided. When the program instructions are executed by a processor, steps of the foregoing battery capacity confidence level determining method are implemented; or when the program instructions are executed by a processor, steps of the foregoing battery capacity determining method are implemented, or when the program instructions are executed by a processor, steps of the foregoing battery capacity state of health determining method are implemented. For example, the non-volatile storage medium may be the foregoing memory 432 including program instructions, and the foregoing program instructions may be executed by the processor 422 of the battery capacity determining apparatus 400, to complete the foregoing battery capacity determining method.

In another example embodiment, a computer program product is further provided. The computer program product includes a computer program that can be executed by a programmable apparatus. The computer program has a code part for executing the foregoing battery capacity confidence level determining method, or a code part for executing the foregoing battery capacity determining method, or a code part for executing the foregoing battery capacity determining method, or a code part for executing the foregoing battery capacity state of health determining method when the computer program is executed by the programmable apparatus.

Implementations of the present disclosure are described in detail above with reference to the accompanying drawings. However, the present disclosure is not limited to specific details in the foregoing implementations. Within a technical concept scope of the present disclosure, a plurality of simple variations may be made to the technical solutions of the present disclosure. These simple variations fall within the protection scope of the present disclosure.

In addition, it will be noted that the specific technical features described in the foregoing specific implementations may be combined in any appropriate manner if there is no conflict. To avoid unnecessary repetition, various possible combinations are not described in the present disclosure.

In addition, various different implementations of the present disclosure may be arbitrarily combined, provided that the implementations do not violate the idea of the present disclosure, which will also be considered as the content disclosed in the present disclosure.

## Claims

1. A battery capacity confidence level determining method, comprising:
determining a target algorithm based on a trigger parameter of a target battery, and the target algorithm being at least one of a plurality of preset algorithms (S101);
obtaining a candidate confidence level set according to the target algorithm and a target operating parameter of the target battery that corresponds to the target algorithm, and the candidate confidence level set comprising a candidate capacity confidence level corresponding to a candidate battery capacity obtained through calculation according to each preset algorithm in the target algorithm (S102); and
determining a target capacity confidence level of the target battery based on an original capacity confidence level corresponding to an original battery capacity and a candidate capacity confidence level corresponding to each candidate battery capacity (S103).

2. The battery capacity confidence level determining method according to claim 1, wherein
the plurality of preset algorithms comprise at least two of an ampere-hour integral method, an inflection point positioning method, and a calendar-life method; and
the trigger parameter comprises at least one of a first state of charge, a second state of charge, and a charging rate that are of the target battery during charging, and the first state of charge is less than the second state of charge.

3. The battery capacity confidence level determining method according to claim 2, wherein
determining the target algorithm based on the trigger parameter of the target battery comprises:
when the first state of charge is less than a first preset threshold and the second state of charge is a full charging state, determining that the target algorithm comprises the ampere-hour integral method and the calendar-life method.

4. The battery capacity confidence level determining method according to either of claims 2 and 3, wherein
determining the target algorithm based on the trigger parameter of the target battery comprises:
when the first state of charge is less than a second preset threshold, the second state of charge is a full charging state, and the charging rate is less than a preset rate, determining that the target algorithm comprises the inflection point positioning method and the calendar-life method.

5. The battery capacity confidence level determining method according to any one of claims 2 to 4, wherein the target operating parameter comprises a confidence level parameter; and
obtaining the candidate confidence level set according to the target algorithm and the target operating parameter of the target battery that corresponds to the target algorithm comprises:
for any preset algorithm in the target algorithm, determining, based on a confidence level parameter corresponding to the preset algorithm, a candidate capacity confidence level of a candidate battery capacity corresponding to the preset algorithm.

6. The battery capacity confidence level determining method according to claim 5, wherein when any preset algorithm is the ampere-hour integral method, the confidence level parameter comprises a static voltage corresponding to the first state of charge and stabilization duration corresponding to the static voltage; and
determining, based on the confidence level parameter corresponding to the preset algorithm, the candidate capacity confidence level of the candidate battery capacity corresponding to the preset algorithm comprises:
determining, based on the stabilization duration of the static voltage and a target interval in which the static voltage is located, a first candidate capacity confidence level of a candidate battery capacity corresponding to the ampere-hour integral method, the target interval being one of a platform region and a ramp region of a low charge interval in a voltage characteristic curve of the target battery, and the first candidate capacity confidence level being positively correlated with the stabilization duration.

7. The battery capacity confidence level determining method according to any one of claims 5 to 6, wherein when any preset algorithm is the inflection point positioning method, the confidence level parameter comprises a candidate state of health of the target battery; and
determining, based on the confidence level parameter corresponding to the preset algorithm, the candidate capacity confidence level of the candidate battery capacity corresponding to the preset algorithm comprises:
determining, based on the candidate state of health of the target battery, a second candidate capacity confidence level of a candidate battery capacity corresponding to the inflection point positioning method, and the second candidate capacity confidence level being positively correlated with the candidate state of health.

8. The battery capacity confidence level determining method according to any one of claims 5 to 7, wherein when any preset algorithm is the calendar-life method, the confidence level parameter comprises a drive mileage and a drive time of the target battery; and
determining, based on the confidence level parameter corresponding to the preset algorithm, the candidate capacity confidence level of the candidate battery capacity corresponding to the preset algorithm comprises:
determining, based on the drive mileage and the drive time, a third candidate capacity confidence level of a candidate battery capacity corresponding to the calendar-life method, and the third candidate capacity confidence level being negatively related to the drive mileage and the drive time.

9. The battery capacity confidence level determining method according to any one of claims 1 to 8, wherein before determining the target capacity confidence level of the target battery based on the original capacity confidence level corresponding to the original battery capacity and the candidate capacity confidence level corresponding to each candidate battery capacity, the method further comprises:
obtaining a fourth candidate capacity confidence level corresponding to the original battery capacity and original update duration, and the original update duration being duration from a moment at which a battery capacity of the target battery is updated to the original battery capacity to a current moment; and
determining, based on the fourth candidate capacity confidence level and the original update duration, the original capacity confidence level corresponding to the original battery capacity, and the original capacity confidence level being negatively correlated with the original update duration.

10. The battery capacity confidence level determining method according to any one of claims 1 to 8, wherein before determining the target capacity confidence level of the target battery based on the original capacity confidence level corresponding to the original battery capacity and the candidate capacity confidence level corresponding to each candidate battery capacity, the method further comprises:
obtaining a fourth candidate capacity confidence level corresponding to the original battery capacity and an original throughput, and the original throughput being a total charging/discharging amount of the target battery in a time period corresponding to an original update duration; and
determining, based on the fourth candidate capacity confidence level and the original throughput, the original capacity confidence level corresponding to the original battery capacity, and the original capacity confidence level being negatively correlated with the original throughput.

11. A battery capacity determining method, comprising:
determining a target algorithm based on a trigger parameter of a target battery, and the target algorithm being at least one of a plurality of preset algorithms;
obtaining a candidate battery capacity set according to the target algorithm and a target operating parameter of the target battery that corresponds to the target algorithm, and the candidate battery capacity set comprising a candidate battery capacity obtained through calculation according to each preset algorithm in the target algorithm; and
determining a candidate battery capacity obtained through calculation according to a preset algorithm corresponding to a target capacity confidence level as a target battery capacity of the target battery, the target battery capacity being used to update a current original battery capacity, and the target capacity confidence level being obtained according to the battery capacity confidence level determining method according to any one of claims 1 to 10.

12. The battery capacity determining method according to claim 11, wherein the target operating parameter comprises a capacity parameter; and
obtaining the candidate battery capacity set according to the target algorithm and the target operating parameter of the target battery that corresponds to the target algorithm comprises:
for any preset algorithm in the target algorithm, determining, based on a capacity parameter corresponding to the preset algorithm, a candidate battery capacity corresponding to the preset algorithm.

13. A battery capacity state of health determining method, comprising:
determining a battery capacity state of health of a target battery based on a target battery capacity and a factory capacity of the target battery, and the target battery capacity being obtained according to the battery capacity determining method according to either of claims 11 and 12.

14. A non-volatile storage medium, wherein the non-volatile storage medium stores a computer program, and when the program is executed by a processor, steps of the battery capacity confidence level determining method according to any one of claims 1 to 10 are implemented; or when the program is executed by a processor, steps of the battery capacity determining method according to either of claims 11 and 12 are implemented; or when the program is executed by a processor, steps of the battery capacity state of health determining method according to claim 13 are implemented.

15. An apparatus, comprising:
a memory (432), storing a computer program; and
a processor (422), configured to execute the computer program in the memory (432), to enable the apparatus (400) to perform steps of the battery capacity confidence level determining method according to any one of claims 1 to 10, or to enable the apparatus (400) to perform steps of the battery capacity determining method according to either of claims 11 and 12, or to enable the apparatus (400) to perform steps of the battery capacity state of health determining method according to claim 13.

16. An electric energy device, comprising the apparatus (400) according to claim 15.
